# EUROPEAN PATENT SPECIFICATION

(11) **EP 3 379 556 B1**
(45) Date of publication and mention of the grant of the patent: **10.07.2019**
(21) Application number: 17000452.7
(22) Date of filing: 20.03.2017
(51) Int. Cl.: H01J 37/10, H01J 37/28

(54) **SCANNING TRANSMISSION ELECTRON MICROSCOPE WITH A CONDENSER OBJECTIVE SYSTEM AND A METHOD OF USE THEREOF**
RASTERTRANSMISSION-ELEKTRONENMIKROSKOP MIT KONDENSATOROBJEKTIVSYSTEM UND VERFAHREN ZUR VERWENDUNG DAVON
MICROSCOPE ÉLECTRONIQUE PAR TRANSMISSION À BALAYAGE AVEC SYSTÈME D'OBJECTIF DE CONDENSATEUR ET SON PROCÉDÉ D'UTILISATION

(43) Date of publication of application: 26.09.2018
(73) Proprietor: TESCAN Brno, s.r.o., 62300 Brno (CZ); Tescan Tempe, LLC., Tempe, AZ 85281 (US)
(72) Inventor: Petras, Stanislav, 38601 Strakonice (CZ); Lencová, Bohumila, 66435 Kurim (CZ); Benner, Gerd Ludwig, 73434 Aalen (DE); Weiss, Jon Karl, Tempe, Arizona 85282 (US)
(74) Representative: Kendereski, Dusan

(56) References cited:
- EP-A2- 0 352 552
- EP-A2- 1 437 759
- JP-A- S57 189 442
- US-A1- 2015 144 787

## Description

### Field of the invention

The present invention relates to a scanning transmission electron microscope.

### State of the art

A scanning transmission electron microscope (STEM) is a powerful instrument for an analysis of the morphology, structure and composition of various samples. In the basic arrangement, STEMs typically consist of a source of electrons, a condenser lens system which forms a primary beam, an objective electromagnetic lens which generates a small electron spot and a scattering angle distribution image, mostly a projection lens system which adjusts the scattering angle range in the detection plane, and a detection system which detects the scattered electrons.

The electron gun - consisting of a (heated/cold) electron emitter, an extraction or control electrode and (multiple) accelerator electrodes - generates a real or virtual electron source (cross-over). The electrons emerging from the cross-over are focused by the condenser lens system and the objective pre-field lens into the sample and compose the primary beam.

The primary beam is characterized by three parameters: a spot size d, a convergence angle *α* and a probe current *Iₚ*. Said parameters are linked together by a parameter called brightness. In principle, the brightness is a system constant, but since the spot size in the sample is limited by the diffraction disk and the axial aberrations, the brightness also depends on the convergence angle. From that point of view, the convergence angle is a crucial parameter which influences the effective spot size and hence the resolution of the STEM. The convergence angle can be adjusted by a mechanically exchangeable aperture or by the multi-hole aperture and deflection system as it was disclosed in a prior art. However, using mechanical parts for changing the convergence angle has several disadvantages such as increased price, decrease in the stability of the electron beam or necessity of the deflection system.

The electron beam generated in the electron source passes through the condenser lens system which typically consists of three lenses (C1, C2 and C3). Moreover, the aperture used for the restriction of the electron beam is placed either above or below the condenser system. In combination with this condenser aperture, the set of condenser lenses is used for changing at least two parameters of the electron beam. Firstly, the beam current can be varied by changing the C1 and C2 excitation. Secondly, the convergence angle can be varied by changing the excitation of C2 and C3 condenser lenses. After the adjustment of the parameters the electron beam impinges on the sample which is normally placed symmetrically in the centre of the pole piece gap of the objective electromagnetic lens. The transmitted electrons provide the information about the sample down to the atomic scale. The electrons which pass through the sample with no scattering or with a small scattering angle are defined as a bright field (BF) electrons. All scattered electrons lying outside the primary illumination cone are named dark field (DF) electrons. The transmitted BF and DF electrons are focused by the objective imaging lens(es) according to their scattering angle in a diffraction pattern (BF/DF) located in a back focal plane of the objective electromagnetic lens. This diffraction pattern is then magnified by the projector lens system on the recording system (CMOS camera, STEM detector).

Scanning coils which are used for scanning a fine beam spot over a field of view on the sample are essential parts of the STEM. The scanning coils placed above the objective electromagnetic lens (or more preciously above an upper pole piece of the objective electromagnetic lens) shift the spot with convergence angle in the range of 10 mrad over the sample.

From the point of view of particle optics, the objective electromagnetic lens consists of at least two lenses. The field above the sample forms the so-called pre-field lens and the field below the sample generates one (or more) imaging lenses.

Although the STEM instruments are at the top of technological branch, there still remain imperfections in the form of lens aberration, such as spherical aberration. To minimize the axial aberration, the pole piece gap can be reduced till the saturation level of the objective electromagnetic lens is reached. However, there are limitations in the reduction of the pole piece gap not only due to mechanical standpoint concerning the arrangement of stage and apertures for the STEMs operating at 100 kV and below, but also because there has to be balance between minimum resolution and maximum sample tilt and detection efficiency. Instead of reducing the pole piece gap, it is more convenient to place the sample asymmetrical in pole piece gap to keep the high-resolution performance.

A lot of technical solutions were used for detection of transmitted electrons, both the BF and DF electrons. In the US7105816, a specialized STEM with high angle annular dark field detector arranged under the objective electromagnetic lens is claimed, in which the variation of the detection range of scattered electrons is done by a mechanical movement of this detector in the axial direction. By contrast, the bright field detector placed under the high angle annular dark field detector is used for the detection of electrons which pass through the sample without (or with very small) scattering.

In the patent application US2015/0144787, an additional lens under the objective electromagnetic lens is used to adjust the range of the scattering angle.

Both of said technical solutions limit the use of de-scanning coils which are necessary for higher scan fields and precession. Furthermore, due to missing multistage projector lens system, the diffraction pattern is out of focus which does not allow the use of some diffraction applications (CBED, SA diffraction).

Besides the BF and DF signals, the other types of information such as x-ray could be gained from the sample. An appropriate detection system for this additional information is needed in the space close to the sample.

The US8476589 describes a double detector system where at least one detector is arranged above the sample plane and at least one detector is placed below the sample plane. (Here and afterwards, position above the sample generally means the position in the space between the electron source and the sample plane. By contrast, position below the sample generally means the position in the space between the sample plane and the detector.) Besides the technical complexity, the price increase due to two different detectors also represents a very negative aspect of this technical solution.

Moreover, Fig.3 in US8080791 shows two (or more in another embodiments) detectors arranged above the sample which is placed asymmetrically in the pole piece gap of the objective electromagnetic lens. The disadvantage of this approach is that the pre-field provides much higher aberration coefficient if the sample is arranged close to the lower pole piece face. Since the minimization of the aberration coefficient is crucial for the high-resolution performance of the microscope, placing the detectors above the sample is not convenient.

### Summary of the invention

Under such circumstances, it is an object of the present invention to provide a scanning transmission electron microscope comprising an electron source configured to provide an electron beam with cross-over, a first condenser lens, a condenser aperture, a condenser zoom system, an objective electromagnetic lens comprising an upper pole piece face and a lower pole piece face configured to provide a pre-field and a post-field (the upper pole piece as well as the lower pole piece are expanded parts of the objective electromagnetic lens which have generally faces, i.e. surfaces oriented towards a sample plane), a sample plane and a detection system, wherein the condenser aperture is placed between the first condenser lens and the condenser zoom system and the condenser aperture together with the first condenser lens are configured to change the beam current.

Furthermore, in the present invention, the condenser zoom system consists of the second condenser lens and the third condenser lens, wherein the condenser zoom system is configured to change at least one parameter from a group of a convergence angle and a spot size.

In order to overcome above mentioned disadvantages, the sample plane is placed asymmetrically between the upper pole piece face and the lower pole piece face of the objective electromagnetic lens in such a way that the distance between the sample plane and the upper pole piece face is smaller than the distance between the sample plane and the lower pole piece face.

To provide an additional feature, the scanning transmission electron microscope further comprises an EDS detector which is placed between the sample plane and the lower pole piece face of the objective electromagnetic lens and which is mounted on an arm, wherein the arm is configured to provide linear movement of the EDS detector.

In order to achieve safe operation mode of the EDS detector in the scanning transmission electron microscope, the beam blanker placed under the condenser zoom system is connected to the control unit and the retractable EDS detector is connected to the control unit, wherein the EDS detector is configured to collect the X-ray signal raised by the interaction of the electron beam with the sample, wherein the EDS detector is configured to transform X-ray signal into electrical signal, wherein the control unit is configured to blank the electron beam if the electrical signal provided by the EDS detector reaches the safety threshold value.

The present invention also provides a method of using scanning transmission electron microscope which comprises an electron source configured to provide an electron primary beam with cross-over, a condenser lens system consisting of a first condenser lens, a condenser aperture, a condenser zoom system, an objective electromagnetic lens comprising an upper pole piece and a lower pole piece configured to provide a pre-field and a post-field, a sample plane and a detection system, in which the first condenser lens and the condenser aperture change the beam current.

### Brief description of drawings

Figure 1 is a schematic drawing of condenser system.
Figure 2 is a schematic drawing of an objective electromagnetic lens.
Figure 3 is a schematic drawing of basic condenser objective lens system.
Figure 4 is a graph of dependence of the effective spot size on the beam current with respect to different convergence angles.

### Detailed description

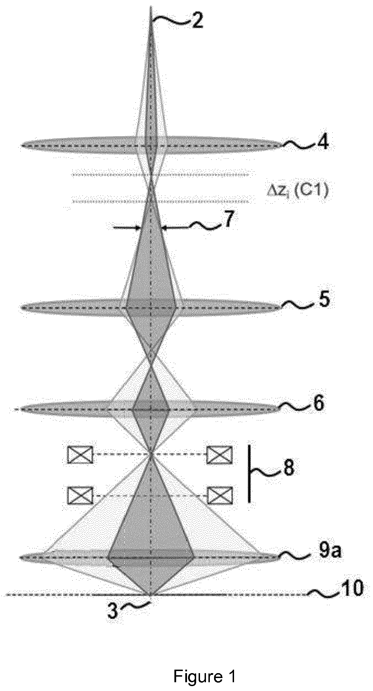

Figure 1 is a schematic drawing of a cross-section of the condenser lens system of the present invention. A primary beam 2 passes through a first condenser lens C1 4 which focuses a cross-over (CO) image into an axial position zᵢ(C1). The axial position of the CO image zᵢ(C1) is placed between the first condenser lens C1 4 and a condenser zoom system, i.e. a second condenser lens C2 5 and a third condenser lens C3 6. A condenser aperture 7 is mounted between the first condenser lens C1 4 and the second condenser lens C2 5. The primary beam 2 passes through the condenser aperture 7 which causes its restriction. The restriction of the primary beam 2 causes the change of the beam current of the primary beam 2. The axial position of the CO image zᵢ(C1) depends on the excitation of the first condenser lens C1 4. Changing the excitation of the first condenser lens C1 4 thus results in the change of the axial position zᵢ(C1) of Δzᵢ(C1). Such variation of the axial position of the CO image zᵢ(C1) with regards to the condenser aperture 7 allows beam current of the primary beam 2 to change without using any mechanically movable parts. In the following step, the condenser zoom system consisting of the second condenser lens C2 5 and the third condenser lens C3 6 transfers the CO image with variable magnification into the fixed entrance image plane of a pre-field lens 9a. The pre-field lens 9a generates a strongly de-magnified (≈40x) image of the CO in a sample plane 10. The condenser zoom system magnification can be optimized in such a way that the effective spot size, which includes the axial aberrations and diffraction disc, is minimal for the given beam current.

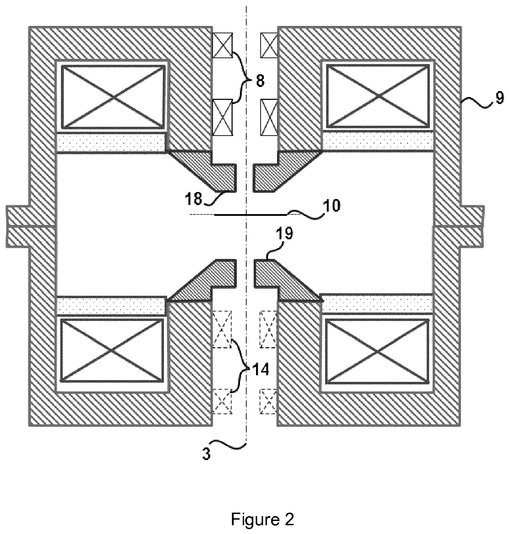

Figure 2 is a schematic drawing of an objective electromagnetic lens 9. Generally, the objective electromagnetic lens 9 is part of the electron microscope with cylindrical symmetry. There are two coils (marked as a rectangle with cross) inside the objective electromagnetic lens 9 which provide the magnetic field. The magnetic field protrudes towards an optical axis 3. The shape of said magnetic field is defined by the shape of an upper pole piece and a lower pole piece (densely dotted) which are expanded parts of the objective electromagnetic lens 9. Both the upper pole piece and the lower pole piece have their face. It means the flat surfaces which are oriented towards the sample plane 10. The upper pole piece thus has an upper pole piece face 18 while the lower pole piece has the lower pole piece face 19. In addition, there are scanning 8 and de-scanning 14 coils in the vicinity of the objective electromagnetic lens 9. In some embodiments, separate precession and de-precession coils could be placed near the scanning coils 8 and de-scanning coils 14, respectively.

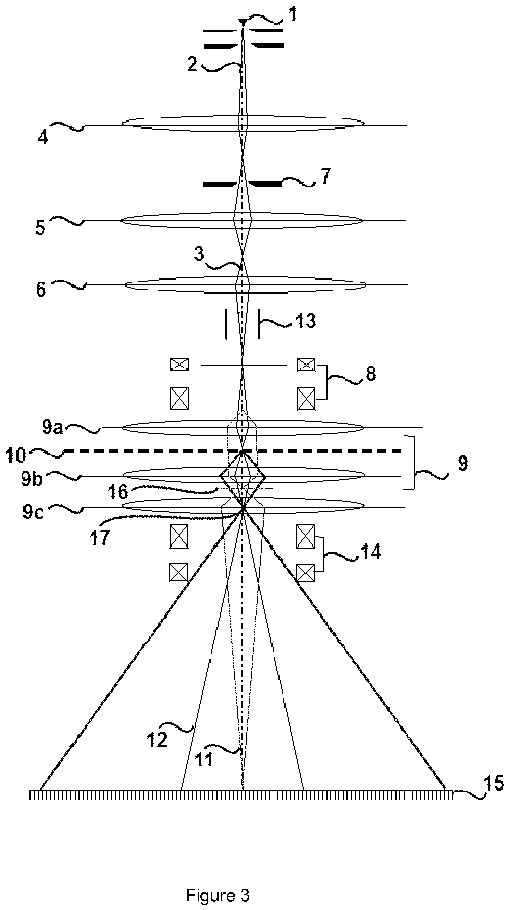

Figure 3 is a schematic drawing of a cross-section of the possible embodiment of the scanning transmission electron microscope which has generally cylindrical symmetry with respect to an optical axis 3. The present invention comprises an electron beam source 1 which produces a primary beam 2 of electrons of various energies. The primary beam 2 passes through the set of three electromagnetic lenses called condenser lens system which consists of three condenser lenses C1 4, C2 5 and C3 6. Here and afterwards, we will distinguish between two terms - an electromagnetic lens and a lens. The electromagnetic lens (as shown for example in Fig. 2) is a physical part of the electron microscope comprising coils which produce magnetic field and a magnetic body with pole pieces which directs and shapes the magnetic field. By contrast, the lens is generated by the field in a gap of the iron circuit, usually inside the electromagnetic lens, which has the effect of lens with a variable focal length for passing charged particles such as electrons. Basically, the lens is the result of the magnetic field generated by the electromagnetic lens on electrons. The first condenser lens C1 4 together with the condenser aperture 7 are configured to change the beam current. The second condenser lens C2 5 and the third condenser lens C3 6, the so-called condenser zoom system, are configured to change at least one parameter of the primary beam 2 from the group of convergence angle and spot size. In the preferred embodiment, the condenser aperture is placed between the first condenser lens C1 4 and the second condenser lens 5.

In this preferred embodiment, the first condenser lens C1 4 together with the condenser aperture 7 are configured to change the beam current of the primary beam 2. The condenser zoom system is then configured to change at least one parameter of the electron beam such as the diameter of the beam spot. An electrostatic beam blanker 13 consisting of two plates is arranged below the condenser lens system and can be used to blank the beam during switching periods, the flyback and to protect the detection system and also during detector read-out of cameras. After the electrons of the primary beam 2 pass through the condenser lens system, they continue to scanning and precession coils 8. Scanning and precession coils 8 are configured to scan the primary beam 2 over the sample which is placed in a sample plane 10 and circulate the primary beam 2 at the sample plane 10 for precession electron diffraction mode in STEM. After passing (in the direction of the primary beam 2) the scanning and precession coils 8, electrons enter an objective electromagnetic lens 9 of the STEM. Such an objective electromagnetic lens generally has expanded parts called two pole pieces (an upper pole piece which is closer to the electron source 1 in the primary beam 2 direction and a lower pole piece which is further from the electron source 1 in the primary beam 2 direction) between which the magnetic field generated by the coils (placed inside the objective electromagnetic lens 9) protrudes to the sample plane 10 which is also placed between said pole pieces. In addition, the upper pole piece as well as the lower pole piece have generally faces, i.e. flat surfaces oriented towards the sample plane 10. The magnitude of the magnetic field generated by the coils of the objective electromagnetic lens 9 influences the electrons before they enter the sample as well as after they emerge from the sample. This influence has a crucial effect on the subsequent imaging of the scattered electrons.

In the described embodiment, the magnetic field is so strong that it has effect of three different lenses called a pre-field lens 9a, an object lens 9b and a diffraction lens 9c. The pre-field lens 9a is configured to project the cross-over image of the condenser lens system to a sample plane 10. In other words, the pre-field focuses the beam spot on the sample plane 10. Because of the strength of the magnetic field, the sample plane 10 has to be shifted towards the upper pole piece face 18. In ordinary STEMs, the sample plane 10 is placed in the middle between the upper pole piece face 18 and the lower pole piece face 19. Generally, the distance between both pole piece faces is about 5 mm. Thus, the sample plane 10 is approximately 2.5 mm from each pole piece face. In the preferred embodiment, the sample plane 10 is approximately 3 mm from the upper pole piece face 18 and approximately 9 mm from the lower pole piece face 19. This opens the opportunity to place an energy dispersive X-ray (EDS) detector 20 under the sample plane 10. Such arrangement has several advantages. One of them is that the increase in the detection efficiency is achieved. In yet another embodiment, the distance between pole piece faces as well as between sample plane 10 and pole piece faces could be different.

In some embodiments, an EDS detector 20 is mounted on a retractable arm which is configured to move in a linear direction perpendicular to the optical axis 3. Such arrangement allows the EDS detector 20 to be retracted from the pole piece gap space which has a significant importance for some applications and ensures the protection of the detector in special high current application modes. In general, the EDS detector 20 collects the X-ray radiation resulting from the interaction of the primary beam 2 electrons and the atoms of the sample. This radiation is subsequently transformed into electrical signal which is analyzed.

In yet another embodiment, a retractable EDS detector 20 is linked to a control unit. The beam blanker 13 is placed between the electron source 1 and the objective electromagnetic lens 9 and is also linked to the control unit. If the EDS detector 20 is overexposed, i.e. the electrical signal reaches the safety threshold, the beam blanker 13 is blanking the primary beam 2 until the EDS detector 20 processes the incoming signal or until the beam current is reduced. In the preferred embodiment, the beam blanker 13 is placed below the condenser lens system.

At this point, two different groups of rays need to be distinguished. In the first group, the axial rays 12 enter the sample at the point where the optical axis 3 intersects the sample plane 10. During passing through the sample, a portion of the electrons is scattered in the forward direction outside the central cone. All axial electrons are further bent back towards the optical axis 3 by the object lens 9b in such a way that the axial rays 12 have a cross-section with the optical axis 3, i.e. they create an image, in the image plane 17 close to the diffraction lens 9c. For that reason, the axial rays 12 are not further affected by the diffraction lens 9c. After passing through the diffraction lens 9c, the electrons continue to the detector 15. The second group of electrons passes through the sample in parallel to the optical axis 3, but off-axis. These field rays 11 are focused by the object lens 9b in the back focal plane of the object lens 9b. Accordingly, all electrons with the same scattering angle are focused off-axis and create a diffraction image in the first diffraction plane 16 between the object lens 9b and the image plane 17. The first diffraction image is then projected from the first diffraction plane 16 into the detector by the diffraction lens 9c resulting in a superior electron-optical performance compared to solutions where the first projector lens has the diffraction plane arranged far from the diffraction plane 16.

The presented combination of said condenser lens system with condenser aperture 7 and the objective electromagnetic lens 9 providing the strong magnetic field results in the situation where no additional projection system is needed to achieve a sufficient size of the diffraction image on the detector.

The presented combination of said condenser lens system with the condenser aperture could be combined with any other in-lens objective lens.

As already mentioned, the effective spot size does not depend only on the demagnification of the cross-over, but also on the aberration of the lenses and the diffraction disk, which are functions of the convergence angle.

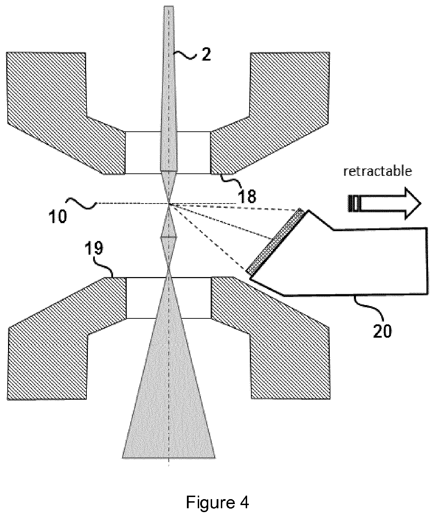

Figure 4 is a schematic drawing of the objective electromagnetic lens 9 with the EDS detector 20 inside. The objective electromagnetic lens 9 comprises of its expanded parts - an upper pole piece and a lower pole piece. The upper pole piece and the lower pole piece comprise their flat surfaces - an upper pole piece face 18 and a lower pole piece face 19. A sample plane 10 is placed inside the pole piece gap, i.e. inside the space between the upper pole piece face 18 and the lower pole piece face 19. The sample plane 10 is placed asymmetrically with respect to the pole piece gap, wherein the distance between the sample plane 10 and the upper pole piece face 18 is smaller than the distance between the sample plane 10 and the lower pole piece face 19. The asymmetrical arrangement of the sample plane 10 gives the opportunity to place the EDS detector 20 below the sample plane 10.

In some embodiments, there could be placed two EDS detectors 20 below the sample plane 10, opposite to each other.

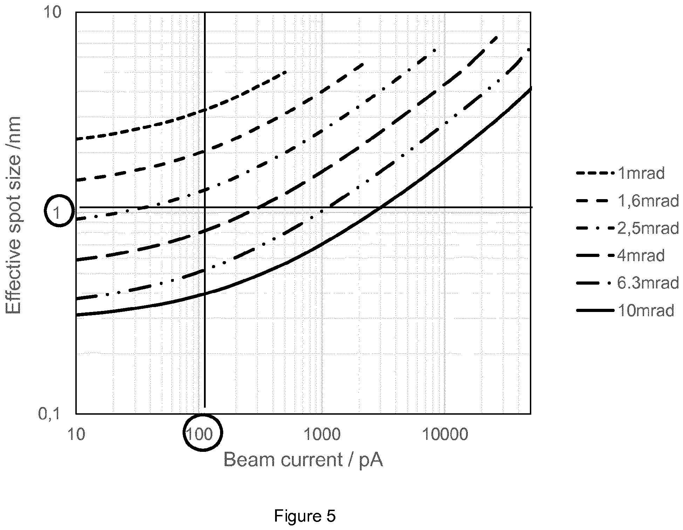

Figure 5 shows an example of an effective probe size as a function of a beam current for different convergence angles in the typical operation range between 1 and 10 mrad for precession and STEM. The beam current is adjusted by selecting a suitable position of a cross-over image with respect to a condenser aperture 7. The excitation of a condenser zoom system can be adjusted to provide a desired convergence angle (within a certain range). This convergence angle results in the effective probe spot size determined by the demagnification of the illumination system and the aberrations. For instance, for the beam current of 100 pA (vertical line), the convergence angle can be adjusted between 1 and 10 mrad. The resulting spot sizes vary from 0.39 nm for 10 mrad to 3.2 nm for 1 mrad. On the other hand, for the spot size of 1 nm (horizontal line) the beam current between 10 pA and 2500 pA can be adjusted according to the needs of the application and radiation sensitivity of the sample.

### List of marks

1 - electron source
2 - primary beam
3 - optical axis
4 - first condenser lens C1
5 - second condenser lens C2
6 - third condenser lens C3
7 - condenser aperture
8 - scanning and precession coils
9 - objective electromagnetic lens
   9a - pre-field
   9b - object lens
   9c - diffraction lens
10 - sample plane
11 - off-axis rays
12 - axial rays
13 - beam blanker
14 - de-scanning and de-precession coils
15 - detector
16 - first diffraction plane
17 - image plane
18 - upper pole piece face
19 - lower pole piece face
20 - EDS detector

## Claims

1. A scanning transmission electron microscope comprising an electron source (1) configured to provide an electron primary beam (2) with a cross-over, a condenser lens system consisting of a first condenser lens (4), a condenser aperture (7) and a condenser zoom system configured to change at least one parameter from a group of a convergence angle and a spot size, the condenser zoom system consisting of a second condenser lens (5) and a third condenser lens (6), an objective electromagnetic lens (9), a sample plane (10) and a detection system, wherein the objective electromagnetic lens (9) comprising an upper pole piece face (18) and a lower pole piece face (19) configured to provide a pre-field and a post-field, **characterized in that** the condenser aperture (7) is placed between the first condenser lens (4) and the condenser zoom system, wherein the first condenser lens (4) and the condenser aperture (7) are configured to change the beam current.

2. The scanning transmission electron microscope according to claim 1 **characterized in that** it further comprises an electrostatic beam blanker (13) integrated in the condenser lens system.

3. The scanning transmission electron microscope according to any of the preceding claims **characterized in that** the sample plane (10) is placed asymmetrically between the upper pole piece face (18) and the lower pole piece face (19).

4. The scanning transmission electron microscope according to any of the preceding claims **characterized in that** the distance between the sample plane (10) and the upper pole piece face (18) is smaller than the distance between the sample plane (10) and the lower pole piece face (19).

5. The scanning transmission electron microscope according to claim 4 **characterized in that** it further comprises an EDS detector (20) placed between the upper pole piece face (18) and the lower pole piece face (19).

6. The scanning transmission electron microscope according to claim 5 **characterized in that** the EDS detector (20) is mounted on an arm, wherein the arm is configured to provide a linear movement of the EDS detector (20).

7. The scanning transmission electron microscope according to claims 5 and 6 **characterized in that** the beam blanker (13) is connected to a control unit and the EDS detector (20) is connected to the same control unit, wherein the EDS detector (20) is configured to collect the X-ray signal raised by the interaction of the electron primary beam (2) with the sample, wherein the EDS detector (20) is configured to transform X-ray signal to electrical signal, wherein the control unit is configured for blanking of the electron primary beam (2) if the electrical signal provided by the EDS detector (20) reaches the safety threshold value.

8. A method of using a scanning transmission electron microscope which comprises an electron source (1) configured to provide an electron primary beam (2) with cross-over, a condenser lens system consisting of a first condenser lens (4) a condenser aperture (7) and a condenser zoom system consisting of a second condenser lens (5) and a third condenser lens (6), an objective electromagnetic lens (9) comprising an upper pole piece face (18) and a lower pole piece face (19) configured to provide a pre-field and a post-field, a sample plane (10) and a detection system, **characterized in that** the excitation of the first condenser lens (4) changes the axial position of the cross-over zᵢ(C1) in the interval Δzᵢ(C1), change of the axial position zᵢ(C1) with respect to the condenser aperture (7) results in change of the beam current, the excitation of the condenser zoom system changes the size of cross-over image or convergence angle of the electron primary beam (2).

9. The method of using scanning transmission electron microscope according to claim 8 **characterized in that** a beam blanker (13) is connected to a control unit and a EDS detector (20) is connected to the control unit, wherein the EDS detector (20) collects the X-ray signal raised by the interaction of the electron primary beam (2) with the sample, wherein the EDS detector (20) transforms X-ray signal to electrical signal, wherein the control unit is blanking the electron primary beam (2) if the electrical signal provided by the EDS detector (20) reaches the safety threshold value.

## Patentansprüche

1. Ein Raster-Transmissions-Elektronenmikroskop umfassend eine Elektronenquelle (1), die zur Bereitstellung eines Primärelektronenstrahls (2) ausgebildet ist mit einem Crossover, ein Kondensorlinsensystem bestehend aus einer ersten Kondensorlinse (4), einer Kondensorblende (7), einem Kondensorzoomsystem, das ausgebildet ist, um mindestens einen Parameter aus einer Gruppe eines Konvergenzwinkels und einer Spotgröße zu ändern, wobei das Kondensorzoomsystem aus einer zweiten Kondensorlinse (5) und einer dritten Kondensorlinse (6) besteht, eine elektromagnetische Objektivlinse (9), eine Probenebene (10) und ein Detektionssystem, wobei die elektromagnetische Objektivlinse (9) eine obere Polschuhfläche (18) und eine untere Polschuhfläche (19) aufweist, die dazu eingerichtet sind, ein Vorfeld und ein Nachfeld bereitzustellen, **dadurch gekennzeichnet, dass** die Kondensorblende (7) zwischen der ersten Kondensorlinse (4) und dem Kondensorzoomsystem angeordnet ist, wobei die erste Kondensorlinse (4) und die Kondensorblende (7) ausgebildet sind, um den Strahlstrom zu ändern.

2. Das Raster-Transmissions-Elektronenmikroskop nach Anspruch 1, **dadurch gekennzeichnet, dass** es ferner einen in das Kondensorlinsensystem integrierten elektrostatischen Strahlaustaster (13) umfasst.

3. Das Raster-Transmissions-Elektronenmikroskop nach einem der vorhergehenden Ansprüche, **dadurch gekennzeichnet, dass** die Probenebene (10) asymmetrisch zwischen der oberen Polschuhfläche (18) und der unteren Polschuhfläche (19) angeordnet ist.

4. Das Raster-Transmissions-Elektronenmikroskop nach einem der vorhergehenden Ansprüche, **dadurch gekennzeichnet, dass** der Abstand zwischen der Probenebene (10) und der oberen Polschuhfläche (18) kleiner ist als der Abstand zwischen der Probenebene (10) und der unteren Polschuhfläche (19).

5. Das Raster-Transmissions-Elektronenmikroskop nach Anspruch 4, **dadurch gekennzeichnet, dass** es ferner einen EDS-Detektor (20) umfasst, der zwischen der oberen Polschuhfläche (18) und der unteren Polschuhfläche (19) angeordnet ist.

6. Das Raster-Transmissions-Elektronenmikroskop nach Anspruch 5, **dadurch gekennzeichnet, dass** der EDS-Detektor (20) an einem Arm gelagert ist, wobei der Arm zur Bereitstellung einer linearen Bewegung des EDS-Detektors (20) ausgebildet ist.

7. Das Raster-Transmissions-Elektronenmikroskop nach den Ansprüchen 5 und 6, **dadurch gekennzeichnet, dass** der Strahlaustaster (13) mit einer Steuereinheit verbunden ist und der EDS-Detektor (20) mit der gleichen Steuereinheit verbunden ist, wobei der EDS-Detektor (20) ausgebildet ist, um das durch Wechselwirkung des Primärelektronenstrahls (2) mit der Probe erzeugte Röntgensignal zu sammeln, wobei der EDS-Detektor (20) eingerichtet ist, ein Röntgensignal in ein elektrisches Signal umzuwandeln, wobei die Steuereinheit dazu eingerichtet ist, den Primärelektronenstrahl (2) in dem Fall auszutasten, wenn das vom EDS-Detektor (20) bereitgestellte elektrische Signal den Sicherheitsschwellwert erreicht.

8. Ein Verfahren zur Verwendung eines Raster-Transmissions-Elektronenmikroskops, umfassend eine Elektronenquelle (1), die zur Bereitstellung eines Primärelektronenstrahls (2) ausgebildet ist mit einem Crossover, ein Kondensorlinsensystem bestehend aus einer ersten Kondensorlinse (4), einer Kondensorblende (7), einem Kondensorzoomsystem bestehend aus einer zweiten Kondensorlinse (5) und einer dritten Kondensorlinse (6), eine elektromagnetische Objektivlinse (9) umfassend eine obere Polschuhfläche (18) und eine untere Polschuhfläche (19), die dazu eingerichtet sind, ein Vorfeld und ein Nachfeld bereitzustellen, eine Probenebene (10) und ein Detektionssystem, **dadurch gekennzeichnet, dass** die Anregung der ersten Kondensorlinse (4) die axiale Position des Crossovers zᵢ(C1) in dem Intervall Δzᵢ(C1) ändert, die Änderung der axialen Position zᵢ(C1) in Bezug auf die Kondensorblende (7) eine Änderung des Strahlstroms zur Folge hat, die Anregung des Kondensorzoomsystems die Größe des Crossover-Bildes oder des Konvergenzwinkels des Elektronenprimärstrahls (2) ändert..

9. Das Verfahren zur Verwendung eines Raster-Transmissions-Elektronenmikroskops nach Anspruch 8, **dadurch gekennzeichnet, dass** ein Strahlaustaster (13) mit einer Steuereinheit verbunden ist und ein EDS-Detektor (20) mit der Steuereinheit verbunden ist, wobei der EDS-Detektor (20) das durch Wechselwirkung des Primärelektronenstrahls (2) mit der Probe erzeugte Röntgensignal sammelt, wobei der EDS-Detektor (20) das Röntgensignal in ein elektrisches Signal umwandelt, wobei die Steuereinheit den Primärelektronenstrahl (2) in dem Fall auszutasten, wenn das vom EDS-Detektor (20) bereitgestellte elektrische Signal den Sicherheitsschwellwert erreicht.

## Revendications

1. Un microscope électronique en transmission à balayage comprenant une source d'électrons (1) configurée pour fournir un faisceau d'électrons primaire (2) avec un point de croisement, un système de lentille condenseur étant constitué d'une première lentille condenseur (4), une ouverture de condenseur (7), un système de zoom de condenseur configuré pour modifier au moins un paramètre à partir d'un groupe formé d'un angle de convergence et d'une taille de point, le système de zoom de condenseur étant constitué d'une deuxième lentille condenseur (5) et d'une troisième lentille condenseur (6), une lentille objectif électromagnétique (9), un plan objet (10) et un système de détection, où la lentille objectif électromagnétique (9) comprend une face polaire supérieure (18) et une face polaire inférieure (19) configurées pour fournir un pré-champ et un post-champ, **caractérisé en ce que** l'ouverture de condenseur (7) est placée entre la première lentille condenseur (4) et le système de zoom de condenseur, où la première lentille condenseur (4) et l'ouverture de condenseur (7) sont configurées pour modifier le courant de faisceau.

2. Le microscope électronique en transmission à balayage selon la revendication 1, **caractérisé en ce qu'il** comprend en outre un obturateur de faisceau électrostatique (13) intégré dans le système de lentille condenseur.

3. Le microscope électronique en transmission à balayage selon l'une des quelconque revendications précédentes, **caractérisé en ce que** le plan objet (10) est disposé de manière asymétrique entre la face de la pièce polaire supérieure (18) et la face de la pièce polaire inférieure (19).

4. Le microscope électronique en transmission à balayage selon l'une des quelconque revendications précédentes, **caractérisé en ce que** la distance entre le plan objet (10) et la face de la pièce polaire supérieure (18) est inférieure à la distance entre le plan objet (10) et la face de la pièce polaire inférieure (19).

5. Le microscope électronique en transmission à balayage selon la revendication 4, **caractérisé en ce qu'**il comprend en outre un détecteur EDS (20) disposé entre la face de la pièce polaire supérieure (18) et la face de la pièce polaire inférieure (19).

6. Le microscope électronique en transmission à balayage selon la revendication 5, **caractérisé en ce que** le détecteur EDS (20) est monté sur un bras, où le bras est configuré pour fournir un mouvement linéaire au détecteur EDS (20).

7. Le microscope électronique en transmission à balayage selon les revendications 5 et 6, **caractérisé en ce que** l'obturateur de faisceau (13) est connecté à une unité de commande et le détecteur EDS (20) est connectée à la même unité de commande, où le détecteur EDS (20) est configuré pour collecter le signal de rayons X émis par l'interaction du faisceau d'électrons primaire (2) avec l'échantillon, où le détecteur EDS (20) est configuré pour transformer un signal de rayons X en un signal électrique, où l'unité de commande est configurée pour dévier le faisceau d'électrons primaire (2) dans le cas où le signal électrique fourni par le détecteur EDS (20) atteint la valeur seuil de sécurité.

8. Un procédé d'utilisation d'un microscope électronique en transmission à balayage qui comprend une source d'électrons (1) configurée pour fournir un faisceau d'électrons primaire (2) avec un point de croisement, un système de lentille condenseur étant constitué d'une première lentille condenseur (4), une ouverture de condenseur (7), et un système de zoom de condenseur consistant en une deuxième lentille condenseur (5) et une troisième lentille condenseur (6), une lentille objectif électromagnétique (9) comprenant une face polaire supérieure (18) et une face polaire inférieure (19) configurées pour fournir un pré-champ et un post-champ, le plan objet (10) et un système de détection, **caractérisé en ce que** l'excitation de la première lentille condenseur (4) change la position axiale du point de croisement zi(C1) dans l'intervalle Δzᵢ(C1), un changement de la position axiale zᵢ(C1) par rapport à l'ouverture de condenseur (7) résulte en un changement du courant de faisceau, l'excitation du système de zoom de condenseur modifie la taille de l'image intermédiaire ou l'angle de convergence du faisceau d'électrons primaire (2).

9. Le procédé d'utilisation d'un microscope électronique en transmission à balayage selon la revendication 8, **caractérisé en ce qu'**un obturateur de faisceau (13) est connecté à une unité de commande et un détecteur EDS (20) est connecté à l'unité de commande, où le détecteur EDS (20) collecte le signal de rayons X émis par l'interaction du faisceau d'électrons primaire (2) avec l'échantillon, où le détecteur EDS (20) transforme un signal de rayons X en un signal électrique, où l'unité de commande dévie le faisceau d'électrons primaire (2) dans le cas où le signal électrique fourni par le détecteur EDS (20) atteint la valeur seuil de sécurité.
